# EUROPEAN PATENT SPECIFICATION

(11) **EP 0 449 823 B1**
(45) Date of publication and mention of the grant of the patent: **05.11.1997**
(21) Application number: 89905523.0
(22) Date of filing: 23.02.1989
(51) Int. Cl.: H03F 3/45

(54) **IMPROVED VARIOLOSSER**
DIFFERENTIELLER VERSTÄRKER
AMPLIFICATEUR DIFFERENTIEL AMELIORE

(30) Priority: 20.12.1988 US 287394
(43) Date of publication of application: 09.10.1991
(73) Proprietor: RESOUND CORPORATION, Redwood City, CA 94063 (US)
(72) Inventor: WALDHAUER, Fred, Donald, La Honda,San Mateo CA 94020 (US); BAEZ, Carlos, Alberto, San Mateo, CA 94402 (US)
(74) Representative: Bowles, Sharon Margaret
(86) International application number: US8900741
(87) International publication number: WO9007231

(56) References cited:
- US-A- 3 727 146

## Description

### FIELD OF THE INVENTION

This invention relates to the field of audio signal processing and specifically to an improved variable gain circuit suitable for use with audio compressors.

### BACKGROUND OF THE INVENTION

Audio compressors are well known devices which are used to modify the dynamic range of an audio signal. An audio compressor may be considered as having two parts: an electronically controlled variolosser or gain adjusting device and a control system with associated circuits to generate control signals which control the gain of the device as a prescribed function of the input (or output) signal. Variolossers are also useful in other applications. For example, a variolosser may be used as a fixed gain device such as a preamplifier or filter with slight modifications.

Audio compressors are characterized in two categories. If the control signals are derived from the input signal of the compressor, the compressor is said to be of the feedforward type; if the control signals are derived from the output of the compressor, the compressor is said to be of the feedback type. The feedforward configuration requires that the dynamic range of the gain control circuitry be equal to that of the input signal. The advantage of this configuration is that the circuit is inherently stable. In a feedback-configuration, a larger range of signals can be accurately processed since the gain control signal samples the output signal which has already been compressed. However, instability is often a problem with feedback compressors. In either of the above cases, a derived control voltage is used to control the loss or gain of the variable loss circuit.

US Patent 3,727,146 describes an electronic gain control circuit designed to provide a linear, temperature stable gain. The circuit includes two pair-wired coupled differential cells and an operational amplifier. The first cell generates two output signals and the input to the cell regulates the total emitter current of the cell. The second differential cell controls the division of the emitter currents and hence the gains of the output of the first cell.

Because of the trend toward miniaturization in electronics today, many audio devices are being designed to operate with single cell batteries. In the field of audio signal processing, a need exists to manufacture compressors, expanders, amplifiers, and filters which may be operated at very low voltages. Low voltage applications for these devices are numerous. However, because of the complexity of the functions provided by compressors and expanders it has previously been impossible to manufacture these circuits in a topology which functions reliably at power supply voltages as low as 1 volt and provide a continuously variable compression ratio.

Operation at low voltage allows a compressor or expander to be powered by a single cell battery. However, operation from a single cell battery severely limits the amount of total power available to the circuitry powered therefrom. Therefore, it is also desirable to design low voltage circuitry wherein the current consumption of the circuitry is minimized.

### SUMMARY OF THE INVENTION

According to the invention there is provided a variable gain circuit comprising: input means for inputting an audio input signal; output means for outputting an audio output signal; amplifier means having an input and an output; a source of reference potential; a first differential cell having inverting and non-inverting inputs, an output and a first control current terminal, wherein one input of said first differential cell is coupled to said output of said amplifier means, and the other of said input is coupled to said source of reference potential; a second differential cell having inverting and non-inverting inputs, an output and a second control current terminal, wherein one input of said second differential cell is coupled to said output of said amplifier means and the other of said inputs is coupled to said source of reference potential and characterized in that the variable gain circuit further includes first and second sources of controlling currents; said output of said first differential cell and the input means are coupled to said input of said amplifier means in a negative feedback relation, and that said first control current terminal is coupled to said first source of controlling current; said output of said second differential cell is coupled to said output means, and said second control current terminal is coupled to said second source of controlling current; and the ratio of said first and second controlling currents controls the gain of said variable gain circuit.

Briefly described, the present invention contemplates an improved variable gain circuit which includes first and second differential cells having inverting and non-inverting input transistors wherein the differential cells include current mirror loads and emitter coupled transistor pairs and further wherein the input of the variable gain circuit comprises the collector of the inverting input transistor of said first differential amplifier. The base of the non-inverting input transistor of said first differential amplifier is coupled to the base of the inverting input transistor of the second differential pair and the base of the inverting input transistor of the first differential amplifier is coupled to the base of the non-inverting input transistor of the second differential amplifier. Transistor bias and feedback is generated by an operational amplifier having its inputs coupled to the input differential pair and its output coupled to the common connection of the base of the non-inverting input transistor of said first differential amplifier and the base of the inverting input transistor of the second differential pair. The present invention further includes first and second current sink means coupled to the common emitters of said first and second differential cells, respectively wherein the ratio of the currents flowing in said current sink means controls the gain of the variable gain circuit.

Accordingly, it is an object of the present invention as it is defined in the appended claims to provide a variable gain circuit which is operable from a low voltage battery.

It is another object of the present invention to provide a variable gain circuit wherein current consumption is minimized.

It is another object of the present invention to provide a variable gain circuit which may be used to expand or compress an audio signal.

It is yet another object of the present invention to provide a continuously variable gain circuit which is easily manufactured in the form of an integrated circuit.

It is still another object of the present invention to provide a continuously variable gain circuit wherein the maximum signal handling capability is provided for the largest input signals.

### BRIEF DESCRIPTION OF THE DRAWING

These and other objects may be fully appreciated through the description below and the accompanying drawing in which:

Figure 1 is a schematic diagram of a prior art compressor adapted for use with a telephone system.

Figure 2 is a schematic diagram of the variable gain circuit of the present invention.

Figure 3 a detailed schematic diagram of the circuit of Figure 2 disposed in a controllable gain configuration.

### DETAILED DESCRIPTION OF THE INVENTION

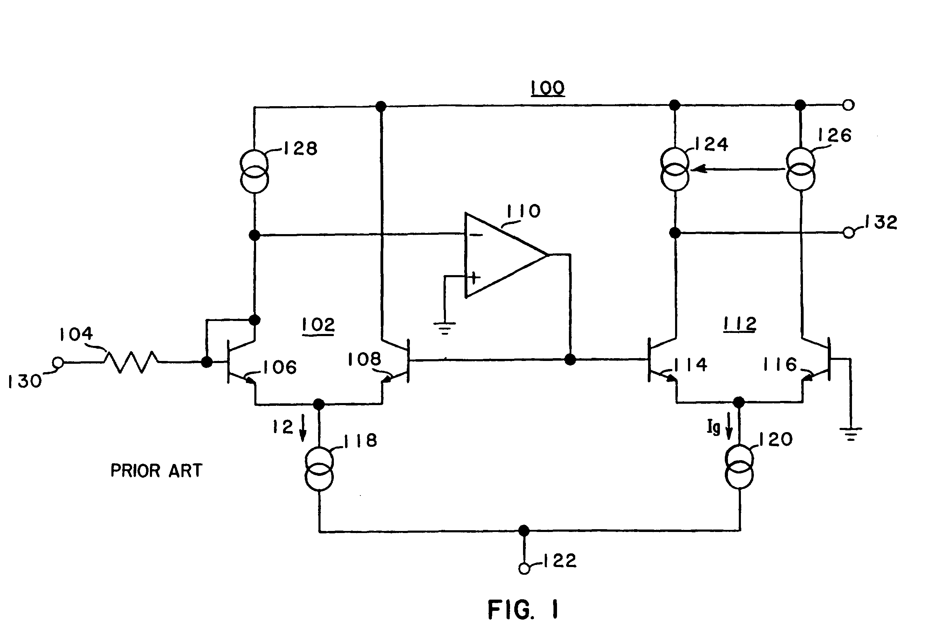

A variable gain circuit is one component of a compressor or expander wherein the gain of the circuit is varied under the control of a control circuit based on a desired relationship between the input and output signals. In the case of the present invention, the variable gain circuit or variolosser is a current multiplier whose transfer function is linear. One example of a prior art variolosser is shown in Figure 1. This device is a Signetics NE572 and it is of the feedback type. In the circuit 100, the input signal is coupled to a differential amplifier 102 through a resistor 104. The differential amplifier 102 is comprised of transistors 106 and 108 which are coupled in a common emitter configuration. The base and collector of transistor 106 are coupled together. The base/collector connection of transistor 106 is further coupled to the input of operational amplifier 110.

The output stage of circuit 100 is comprised of differential pair 112 which is formed by transistors 114 and 116. The base terminal of transistors 108 and transistor 114 is coupled in common. This common connection is further coupled to the output of operational amplifier 110. Current sources 118 and 120 are coupled between the common emitters of differential pairs 102 and 112 and a reference terminal 122. Current sources 124 and 126 are coupled to the collectors of transistors 114 and 116, respectively. Current source 124 is a variable current source whose output current depends on the output of current source 126. A current source 128 is coupled to the collector/base connection of transistor 106.

In this type of variable gain circuit, a compressor is formed by placing the variolosser in the feedback loop of an operational amplifier and accordingly is prone to instability. Current gain in this device is controlled by varying the output current Ig in differential pair 112 relative to the fixed current I2 in differential pair 102. The circuit relies on the virtual ground between the input of operational amplifier 110 (with negative feedback) to maintain equal base-to-emitter voltages between its two emitter coupled pairs 102 and 112 and the input diode formed by transistor 106. As an increasing signal appears at the input terminal 130, the current therefrom is summed with the current generated by current source 128 at the input of operational amplifier 110 which generates a decreasing output voltage in response thereto. This decreasing voltage lowers the base voltage of transistor 114. This in turn causes current sources 124 and 126 to generate a relatively lower current at output terminal 132. In a similar fashion, a decreasing input current at terminal 130 will cause current sources 124 and 126 to generate a relatively higher current at output terminal 132. Therefore, the current consumption of circuit 100 varies as a function of input current.

In order to vary the current gain of circuit 100 from 0 dB to 20 dB, a 20 dB change in the gain control signal (Ig) is required. As a result, the power dissipation of the circuit 100 increases as a function of the gain control signal Ig. In addition, this circuit requires a relatively high voltage (e.g., 5 volts) for proper operation.

The present invention provides an improvement over the circuit 100 by varying the current in the input and output differential cells independently or in opposite directions. A 20 dB increase in current gain is achieved by redistributing the quiescent current between the input and output differential pairs such that the current through the output cell is 20 dB greater than the current through the input cell. As a result, the power dissipation may be independent of the gain set by the cell current control signals.

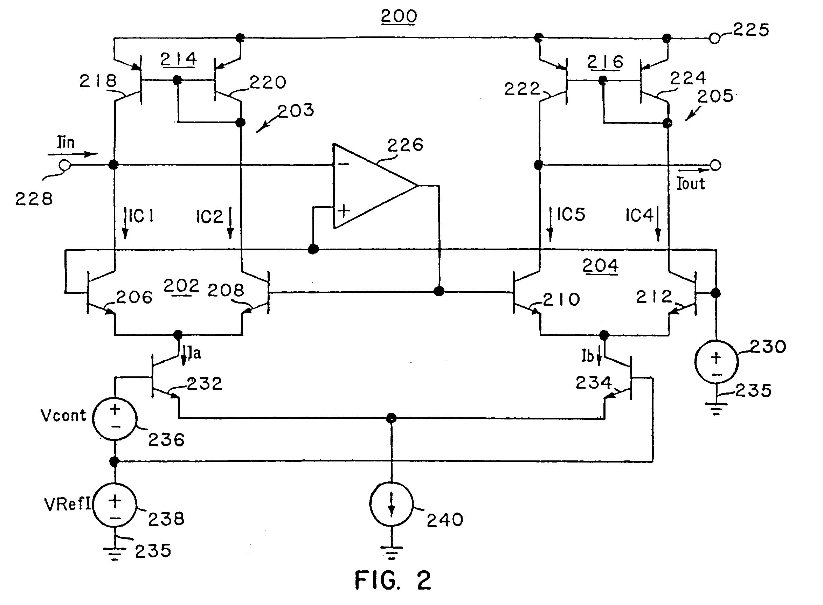

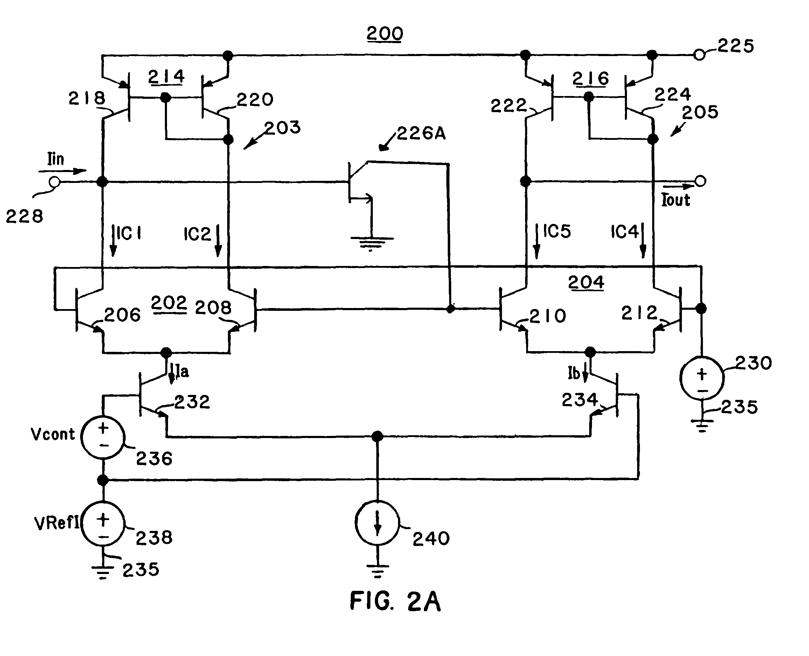

Referring now to Figure 2, the present invention includes differential cells 203 and 205 comprising differential pairs 202 and 204. Differential pair 202 is formed by transistors 206 and 208 and differential pair 204 is formed by transistors 210 and 212, respectively. Each of the differential pairs 202 and 204 are further coupled to current mirror loads 214 and 216, respectively. Current mirror 214 is formed by transistors 218 and 220 which are coupled with their bases in common. Current mirror 216 is formed by transistors 222 and 224 which are coupled with their bases in common. Transistors 220 and 224 are each disposed with their bases and collectors in common and accordingly they function as diodes and are hereinafter referred to as current mirror reference transistors. The current flow out of the collectors of transistors 220 and 224 establishes a base/emitter voltage in the current mirrors which causes a mirrored current to be generated at the collectors of transistors 218 and 222 which is controlled by the relative sizes of the devices. In other words, if for example, transistors 220 and 218 are of identical size, whatever current is generated by transistor 220 will be substantially generated by transistor 218 in a 1-1 relationship.

In the present invention, the differential cells 203 and 205 are coupled in a pairwise configuration. Specifically, the bases of transistors 208 and 210 are coupled together and the bases of transistors 206 and 212 are coupled together. Stated alternatively, the inverting input of differential cell 203 is coupled to the non-inverting input of differential cell 205 and vice versa. Operational amplifier 226 is disposed with its inverting input coupled to the common collector connection of transistors 206 and 218 and its non-inverting input coupled to the common base connection of transistors 206 and 212. The common base connection of transistors 206 and 212 is further coupled to a source of reference potential 230. The output of operational amplifier 226 is coupled to the common base connection of transistors 208 and 210. In another aspect of this invention, the base inputs of output differential cell transistors can be interchanged to provide a phase reversal from input to output.

One interesting aspect of the present invention lies in the fact that the input current at input terminal 228 is applied to the collectors of transistors 206 and 218 in parallel. Positive input currents therefore add directly to the collector current of transistor 206 (and vice versa). By virtue of the pairwise connections of the differential cells 203 and 205, equal base/emitter voltages are generated in transistors 206, 212 and 208, 210. As a result, the ratio of the collector currents in the differential pair 204 is equal to the ratio of the collector currents in differential pair 202.

Negative feedback is generated by operational amplifier 226 and is established through transistors 206 and 208 which provide a low impedance summing node for the input current as well as the proper base bias current for transistors 208 and 210. Under quiescent conditions, (Iin=0) the differential pairs 202 and 204 are balanced with IC1=IC2 and IC4=IC5 (neglecting the small base currents). As the input current increases, increased current IC1 is injected into the collector of transistor 206 and therefore the base/emitter voltage of transistor 206 increases while IC2 and the base/emitter voltage of transistor 208 decreases. Similarly, IC5 and the base/emitter voltage of transistor 210 decreases while IC4 and the base/emitter voltage of transistor 212 increases, thus producing an output current.

In yet another aspect of the present invention, the input signal may be applied to the collectors of transistors 208 and 220. In this case, in order to maintain the negative feedback relation, operational amplifier 226 is disposed with its non-inverting input coupled to the common collector connection of transistors 208 and 220 and its inverting input coupled to the common base connection of transistors 206 and 212.

The ratio of the output current to the input current, the current gain, is determined by the ratio of the total amount of current steered out of the common emitter connections of the differential cells 202 and 204. In other words, the current gain of the variolosser 200 is determined by the ratio of the quiescent collector currents Ia and Ib of transistors 232 and 234 which are coupled to the respective common emitter connections of differential pairs 202 and 204.

The quiescent collector currents of transistors 232 and 234 are controlled by their respective base voltages. Assuming the transistor at the input and output cells are the same size, if Ia is equal to Ib, the gain of circuit 200 is unity. If Ia is smaller than Ib, the gain is greater than unity and vice versa. The respective base voltages of transistors 232 and 234 may be controlled voltage sources 236 and 238. In some applications, voltage source 238 may produce a fixed reference voltage. Voltage source 236 may be a variable voltage source which produces a control voltage (Vcont). Therefore, the relative base voltages of transistors 232 and 234 and the respective currents Ia and Ib may be controlled by Vcont. This control voltage may be derived from a rectifier/filter combination (not shown) coupled to the input signal of circuit 200. It can be positive or negative simply by the choice of rectifier output polarity, thus providing both compression and expansion functions. If Vcont is positive, the circuit 200 functions as a compressor. If Vcont is negative, circuit 200 functions as an expander. Thus, the circuit 200 provides both compression and expansion by merely changing the rectifier polarity. Of course, the variolosser 200 may be operated as a fixed gain device by maintaining Vcont at a constant level.

The variolosser 200 provides a large range of current gain which may be in the range of 80dB under the control of a small linear dc voltage which may be in the range of -120mV to + 120mV. The sensitivity of circuit 200 may therefore be in the range of .334dB/mV. This is achieved by using the control voltage to control the base/emitter voltages of current sink transistors 232 and 234, thereby taking advantage of the exponential relationship between the collector current and the base-emitter voltage of a transistor in the active region.

In the circuit 100, the variolosser relies on the virtual ground between the inputs of operational amplifier 110 (with negative feedback) to maintain equal base/emitter voltages between its two differential amplifiers and has its input applied to a diode. In contrast, the present invention maintains equal base/emitter voltages by direct connection and utilizes feedback around operational amplifier 226 to establish appropriate base current bias. Since the input signal of the circuit 200 is applied to a current mirror that is identical to the output current mirror, by virtue of the pairwise connection of differential cells 203 and 205, current consumption may be held constant regardless of the input signal level.

In another aspect of the present invention, gain reduction occurs as the magnitude of the input signal increases. As mentioned above, the circuit 200 achieves gain reduction by steering more current into its input stage than its output stage. As a result of this action, and the action of the input current mirror, the variolosser exhibits maximum signal handling ability for the largest input signals (minimum gain), since the input signal enters the cell at the point where the largest current is available. The present invention provides a variolosser structure which may be operated successfully at very voltages even with the small transistors used in small integrated circuits. As a result of its low voltage operation, this circuit is well suited for hearing aids and other low voltage applications.

Under some circumstances, the variolosser of the invention may successfully incorporate other suitable amplifier means instead of an operational amplifier such as is shown in Figure 2. Figure 2A illustrates one such alternative embodiment wherein a single MPN transistor 226A is employed as the amplifier means instead of the operational amplifier 226 of Figure 2. The emitter of the transistor 226A is connected to ground. The base of the transistor serves as the input, being connected to the terminal 228. The collector of the transistor 226A is connected to the junction between the basis of the differential pair transistors 208 and 210. It will be apparent to those skilled in the art that control over the gain of the transistor 226A determines the gain of the variolosser and this control is effected in the same way as described in connection with the operational amplifier of Figure 2. Other forms of amplifying devices which could be used in a similar fashion will be apparent to those skilled in the art.

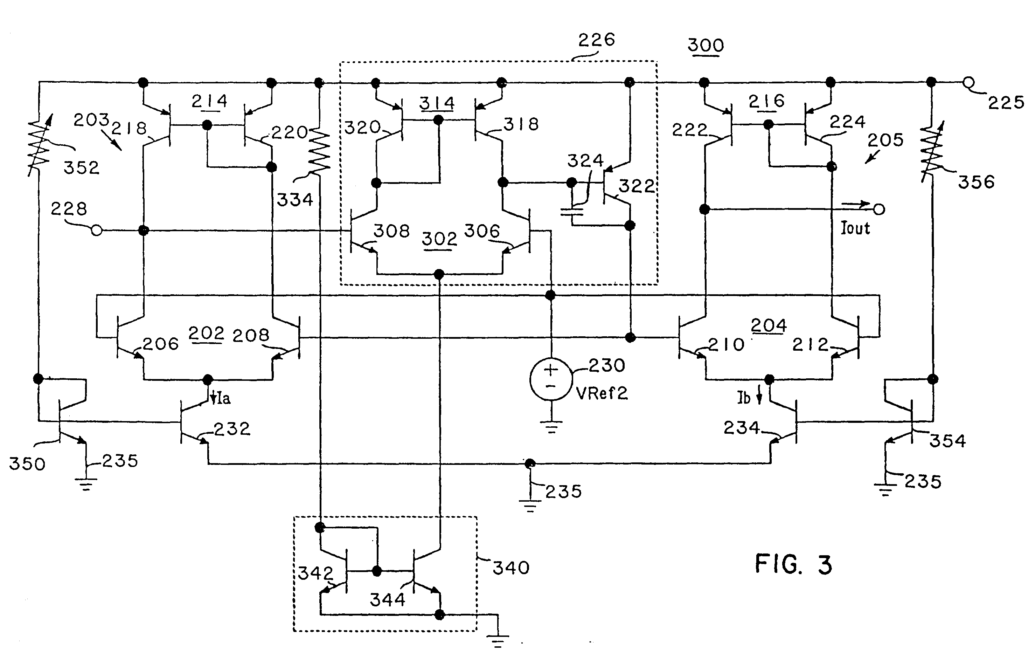

Referring now to Figure 3, there is shown a more detailed schematic of the circuit of Figure 2 which features improved low voltage performance. In the embodiment shown in Figure 3, the variolosser is implemented as an adjustable gain circuit. For the sake of clarity, components which provide identical functions as the components of Figure 2 bear identical designations. As above, the circuit 300 includes differential amplifiers 202 and 204 which are coupled to current mirror loads 214 and 216, respectively. The pairwise connection of the differential cells 203 and 205 is identical to the connections described in conjunction with Figure 2. The operational amplifier 226 is disposed with its inverting input coupled to the common collector connection of transistors 218 and 206 and its non-inverting input is coupled to the common base connection of transistors 206 and 212 and to the source of reference potential 230.

The operational amplifier 226 is formed by a differential pair 302 comprising transistors 306 and 308. These transistors are coupled to a current mirror load 314 formed by transistors 318 and 320 which are disposed with their bases coupled together. The base and collector of transistor 320 are coupled together, thereby forming the diode portion or reference transistor of the current mirror 314. A PNP transistor 322 forms the output stage of operational amplifier 226. The base of PNP transistor 322 is coupled to the common collector connection of transistors 306 and 318. The emitter of PNP transistor 322 is coupled to the power supply input terminal 225 and its collector is coupled to the common base connection of transistors 208 and 210. The configuration of the operational amplifier 226 is well known and its operation will be understood by a person of ordinary skill in the art. Its function in the circuit 300 is identical to the functional operation of operational amplifier 226 described in conjunction with Figure 2.

Reference currents for operational amplifier are provided by the reference current generator 340, which includes NPN transistors 342 and 344 coupled in a current mirror configuration. Each of these transistors are coupled with their emitters coupled to ground terminal 235. The collector of transistor 344 is coupled to the emitter connection of transistors 306 and 308, thereby forming the current sink for differential pair 302. The current sinking capability of reference current generator is controlled by transistor 342, disposed with its collector and base coupled together, and resistor 334. Since transistor 342 is clamped to ground, a fixed voltage drop will be developed across resistor 334 causing a fixed current to flow through resistor 334 into transistor 342 which will be mirrored in transistor 344, thus establishing the current consumption of operational amplifier 226.

As above, the gain of the circuit 300 is set by the ratio of currents Ia and Ib flowing into the collectors of transistors 232 and 234, respectively. These currents may be controlled in a number of ways. In one embodiment, the bases of transistors 232 and 234 could be coupled to the common base connections of the reference current generator 340 and the relative currents flowing in transistors 232 and 234 could be set by controlling the relative areas of the respective devices. In the embodiment shown, transistors 232 and 234 are coupled in current mirror configurations with the addition of transistors 350 and 354, respectively. Transistors 350 and 354 are disposed with their emitters coupled to ground terminal 235 and their collectors and bases coupled in common wherein this common connection is further coupled to the bases of transistors 232 and 234, respectively. Variable resistors 352 and 356 may be coupled between the power supply input terminal 336 and the respective common base/collector connections of transistors 350 and 354 so that the ratio of the settings of variable resistors 352 and 356 controls the gain of circuit 300. As mentioned above, the bias voltage for transistors 232 and 234 may also be generated by a control voltage generator to provide compression and expansion functions.

The low voltage operation aspect of this invention can be appreciated by reference to Figure 3. The circuit 300 is operable from voltages as low as or lower than 1.1 volts. As a result of this low voltage operation, it is well suited for applications such as hearing aids or portable radios. The minimum operating supply voltage for the circuit 300 is determined by the total number of series voltage drops necessary to keep all of the transistors of the circuit in their proper region of operation. Figure 3 shows that the circuit 300 has three critical series voltage drops: the base/emitter voltage of transistor 220, the collector/emitter voltage of transistor 208 and the collector/emitter of voltage of transistor 232. At low bias currents, transistors with appropriately small dimensions for integrated circuits useful in in-the-ear hearing aids will have a base/emitter voltage in the range of .65 volts and a collector/emitter voltage in the range of .15 volts. Therefore, even with these small dimensions, the circuit 300 can be operated from voltages as low as .95 volts.

In summary, a low voltage variable gain circuit has been described. The present invention includes a two stage differential amplifier structure coupled in a pairwise configuration. The feedback and bias level of the circuit is controlled by an operational amplifier coupled to the input differential amplifier. As the gain of the variolosser is varied, current is diverted between the input and output stages so that the total current consumed by the circuit may be held constant regardless of the gain of the device. The unique topology of the present invention allows reliable circuit operation from a low voltage power source. Accordingly, other uses and modifications will be obvious to a person of ordinary skill in the art and all of such modifications are intended to be within the scope of the present invention as claimed in the appended claims.

## Claims

1. A variable gain circuit comprising: input means (228) for inputting an audio input signal(I_{IN}); output means for outputting an audio output signal (I_{OUT}); amplifier means (226/226A) having an input and an output; a source (230) of reference potential; a first differential cell (203) having inverting and non-inverting inputs, an output and a first control current terminal, wherein one input of said first differential cell (203) is coupled to said output of said amplifier means (226/226A), and the other of said input is coupled to said source (230) of reference potential; a second differential cell (205) having inverting and non-inverting inputs, an output and a second control current terminal, wherein one input of said second differential cell (205) is coupled to said output of said amplifier means (226/226A) and the other of said inputs is coupled to said source (230) of reference potential and characterized in that the variable gain circuit further includes first and second sources (232,234,236,238) of controlling currents (Iₐ,I_{b}); said output of said first differential cell (203) and the input means (228) are coupled to said input of said amplifier means (226/226A) in a negative feedback relation, and that said first control current terminal is coupled to said first source (232,236,238) of controlling current (Iₐ); said output of said second differential cell (205) is coupled to said output means (I_{OUT}), and said second control current terminal is coupled to said second source (234,238) of controlling current (I_{b}); and the ratio of said first and second controlling currents (Iₐ,I_{b}) controls the gain of said variable gain circuit.

2. A variable gain circuit according to claim 1 further characterized in that the gain of said circuit is substantially the ratio (I_{b}/Iₐ) of said second controlling current (I_{b}) to said first controlling current (Iₐ).

3. A variable gain circuit according to any preceding claim further characterized in that said amplifier means (226) has a second input, that the first input of said amplifier means (226) is coupled to said input means (228) and the second input of said amplifier means (226) is coupled to said source (230) of reference potential; wherein the non-inverting input of said first differential cell (203) is coupled to the output of said amplifier means (226) and the inverting input of said first differential cell (203) is coupled to said source (230) of reference potential, and wherein the output of said first differential cell (203) is coupled to the first input of said amplifier means (226).

4. A variable gain circuit according to any preceding claim wherein said amplifier means (226/226A) comprises a transistor.

5. A variable gain circuit according to any preceding claim wherein said amplifier means (226) comprises an operational amplifier.

6. A variable gain circuit according to any preceding claim adapted for implementation on an integrated circuit.

7. A variable gain circuit according to any preceding claim wherein said first differential cell (203) comprises first and second NPN emitter coupled transistors (206,208) coupled to a current mirror (214) comprising first and second PNP transistors (218,220), each of said transistors having a base, an emitter and a collector wherein the collectors of said first NPN and PNP transistors (206,218) are coupled together and the collectors of said second NPN and PNP transistors (208,220) are coupled together and further wherein the base and collector of said second PNP transistor (220) are coupled together and the bases of said first and second PNP transistors (218,220) are coupled together, wherein the base of said first NPN transistor (206) comprises the inverting input of said first differential cell (203) and the base of said second NPN transistor (208) comprises the non-inverting input of said differential cell (203) and the collector connection of said first PNP and NPN transistors (206,218) comprises the output of said first differential cell (203), and wherein the emitter connection of said first and second NPN transistors (206,208) is coupled to said first control current terminal.

8. A variable gain circuit according to any preceding claim wherein each of said differential cells (203/205) comprises first and second emitter coupled transistors (206,208/210, 212) coupled to a current mirror (214/216) comprising first and second current mirror transistors (218,220/222,224) of opposite polarity to the polarity of said first and second emitter coupled transistors (206,208/210,212) each of said transistor having a base, an emitter, and a collector, wherein the emitters of said first and second current mirror transistors (218,220,222,224) are coupled to a voltage source (225), wherein the collectors of said first transistors (206,218/210,222) are coupled together and the collectors of said second transistors (208,220/212,224) are coupled together and further wherein the base and collector of said second current mirror transistor (220/224) are coupled together and the bases of said first and second current mirror transistors (218,220/222,224) are coupled together, wherein the base of said first emitter coupled transistor (206/210) comprises the inverting input of said differential cell (203/205) and the base of said second emitter coupled transistor (208,212) comprises the non-inverting input of said differential cell (203/205) and the collector connection of said first transistors (206,218/210, 222) comprises the output of said differential cell (203/205), and wherein the emitter connection of said first and second emitter coupled transistors (206,208/210,212) is coupled to the control current terminal of said differential cell (203/205).

9. A variable gain circuit according to claim 1 further characterized in that said amplifier means (226) comprises an operational amplifier having inverting and non-inverting inputs and an output, in that the inverting input of said operational amplifier is coupled to said input means (228) and said non-inverting input is coupled to said source (230) of reference potential; in that the non-inverting input of said first differential cell (203) is coupled to the output of said operational amplifier, the inverting input of said first differential cell (203) is coupled to said source (230) of reference potential, and the output of said first differential cell (203) is coupled to the inverting input of said operational amplifier; and in that one input of said second differential cell (205) is coupled to the output of said operational amplifier and the other of said inputs of said second differential cell (205) is coupled to said source (230) of reference potential.

10. A variable gain circuit according to any preceding claim wherein the audio output signal (I_{OUT}) of said variable gain circuit is 180° phase shifted with respect to the audio input signal (I_{IN}) at said input means (228).

11. A variable gain circuit according to any of claims 1 to 9 wherein the audio output signal (I_{OUT}) of said variable gain circuit is in phase with respect to the audio input signal (I_{IN}) at said input means (228).

12. A variable gain circuit according to any preceding claim wherein said improved variable circuit is capable of operation at voltages as low as 0.95 volts.

## Patentansprüche

1. Schaltung mit variabler Verstärkung, umfassend:
eingangsseitige Einrichtungen (228) zum Einspeisen eines Tonfrequenzeingangssignales (I_{IN});
ausgangsseitige Einrichtungen zum Abgeben eines Tonfrequenzsignals (I_{OUT}); Verstärklereinrichtungen (226; 226A) mit einem Eingang und einem Ausgang; eine Bezugspotentialquelle (230);
eine erste Differentialzelle (203) mit einem invertierenden und einem nicht-invertierenden Eingang sowie einem Ausgang und einem ersten Steuerstromanschluß, wobei ein Eingang der ersten Differentialzelle (203) mit dem Ausgang der Verstärkereinrichtung (226; 226A) und der andere Eingang mit der Bezugspotentialquelle (230) gekoppelt ist;
eine zweite Differentialzelle (205) mit einem invertierenden und einem nicht-invertierenden Eingang sowie einem Ausgang und einem zweiten Steuerstromanschluß, wobei ein Eingang der zweiten Differentialzelle (205) mit dem Ausgang der Verstärkereinrichtungen (226; 226A) und er andere Eingang mit der Bezugspotentialquelle (230) gekoppelt ist,
**dadurch gekennzeichnet,**
daß die variable Verstärkerschaltung ferner umfaßt:
erste und zweite Quellen (232, 234, 236, 238) für Steuerströme (Iₐ, I_{b});
daß der Ausgang der ersten Differentialzelle (203) und die eingangsseitigen Einrichtungen (228) in einem negativen Rückkopplungsverhältnis mit dem Eingang der Verstärkereinrichtungen (226; 226A) gekoppelt sind;
daß der erste Steuerstromanschluß mit der ersten Quelle (232, 236, 238) für den Steuerstrom (Iₐ) gekoppelt ist;
daß der Ausgang der zweiten Differentialzelle (205) mit an die ausgangsseitigen Einrichtungen (I_{OUT}),
daß der zweite Steuerstromanschluß mit der zweiten Quelle (234, 238) für den Steuerstrom (I_{b}) gekoppelt ist;
und daß das Verhältnis des ersten und zweiten Steuerstroms (Iₐ, _{I}b) die Verstärkung der variablen Verstärkerschaltung steuert.

2. Schaltung mit variabler Verstärkung nach Anspruch 1,
**dadurch gekennzeichnet,**
daß sich die Verstärkung der Schaltung im wesentlichen aus dem Verhältnis (I_{b}/Iₐ) des zweiten Steuerstroms (I_{b}) zum ersten Steuerstrom (Iₐ) ergibt.

3. Schaltung mit varibler Verstärkung nach einem der vorstehenden Ansprüche,
**dadurch gekennzeichnet,**
daß die Verstärkereinrichtung (226) einen zweiten Eingang hat,
daß der erste Eingang der Verstärkereinrichtung (226) mit den eingangsseitigen Einrichtungen (228) und der zweite Eingang der Verstärkereinrichtung (226) mit der Bezugspotentialquelle (230) gekoppelt sind, wobei der nicht-invertierende Eingang der ersten Differentialquelle (203) mit dem Ausgang der Verstärkereinrichtung (226) und der invertierende Eingang der ersten Differentialzelle (203) mit der Bezugspotentialquelle (230) gekoppelt sind,
und daß der Ausgang der ersten Differentialzelle (203) mit dem ersten Eingang der Verstärkereinrichtungen (226) gekopppelt ist.

4. Schaltung mit variabler Verstärkung nach einem der vorstehenden Ansprüche,
**dadurch gekennzeichnet,**
daß die Verstärkereinrichtungen (226/226A) einen Transistor umfassen.

5. Schaltung mit variabler Verstärkung nach einem der vorstehenden Ansprüche,
**dadurch gekennzeichnet,**
daß die Verstärkereinrichtung (226) aus einem Operationsverstärker besteht.

6. Schaltung mit variabler Verstärkung nach einem der vorstehenden Ansprüche,
**dadurch gekennzeichnet,**
daß sie als integrierte Schaltung ausgeführt ist.

7. Schaltung mit variabler Verstärkung nach einem der vorstehenden Ansprüche,
**dadurch gekennzeichnet,**
daß die erste Differentialzelle (203) erste und zweite emittergekoppelte NPN-Transistoren (206, 208) umfaßt, die mit einem Stromspiegel (214) aus ersten und zweiten PNP-Transistoren (218, 220) gekopppelt sind, wobei jeder dieser Transistoren eine Basis, einen Emitter und einen Kollektor aufweist und die Kollektoren der ersten NPN- und PNP-Transistoren (206, 218) sowie die Kollektoren der zweiten NPN- und PNP-Transistoren (208, 220) jeweils zusammengekoppelt sind und wobei ferner die Basis und der Kollektor des zweiten PNP-Transistors (220) und ebenso die Basis des ersten und die Basis des zweiten PNP-Transistors (218, 220) miteinander gekoppelt sind, daß die Basis des ersten NPN-Transistors (206) den invertierenden Eingang der ersten Differentialzelle (203) und die Basis des zweiten NPN-Transistors (208) den nicht-invertierenden Eingang der Differentialzelle (203) darstellt, wobei die Kollektoren des ersten PNP- und NPN-Transistors (206, 218) miteinander verbunden sind und den Ausgang der ersten Differentialzelle (203) darstellen, und daß die Emitterverbindung der ersten und zweiten NPN-Transistoren (206, 208) mit dem ersten Steuerstromanschluß gekoppelt ist.

8. Schaltung mit variabler Verstärkung nach einemd er vorstehenden Ansprüche,
**dadurch gekennzeichnet,**
daß jede der Differentialzellen (203/205) erste und zweite emittergekoppelte Transistoren (206, 208; 210, 212) umfaßt, die mit je einem Stromspiegel (214; 216) gekoppelt sind und welche erste und zweite Stromspiegeltransistoren (218, 220, 222, 224) mit einer der Polarität der ersten und zweiten emittergekoppelten Transistoren (206, 208; 210, 212) entgegengesetzte Polarität haben, wobei jeder Transistor eine Basis, einen Emitter und einen Kollektor aufweist,
daß die Emitter der ersten und zweiten Stromspiegeltransistoren (218, 220; 222, 224) mit einer Spannungsquelle (225) gekoppelt sind,
daß die Kollektoren der ersten Transistoren (206, 218; 210, 222) einerseits und die Kollektoren der zweiten Transistoren (208, 220; 212, 224) andererseits miteinander gekoppelt sind,daß ferner die Basis und der Kollektor der zweiten Stromspiegeltransistoren (220; 224) und ebenso die Basis der ersten und zweiten Stromspiegeltransistoren (218, 220; 222, 224) miteinander gekoppelt sind,
daß die Basis des ersten emittergekoppelten Transistors (206; 210) jeweils den ersten invertierenden Eingang der Differentialzelle (203; 205) einerseits und die Basis des zweiten emittergekoppelten Transistors (208, 212) den nicht-invertierenden Eingang der jeweiligen Differentialzelle (203; 205) darstellt, wobei die Kollektorverbindung der ersten Transistoren (206, 218; 210, 222) den Ausgang der jeweiligen Differentialzelle (203; 205) darstellen und
daß die Emitterverbindung der ersten und zweiten emittergekoppelten Transistoren (206, 208; 210, 212) mit dem Steuerstromanschluß der jeweiligen Differentialzelle (203/205) gekoppelt ist.

9. Schaltung mit variabler Verstärkung nach Anspruch 1,
**dadurch gekennzeichnet,**
daß die Verstärkereinrichtung (226) aus einem Operationsverstärker mit einem invertierenden und einem nicht-invertierenden Eingang sowie einem Ausgang besteht, wobei dessen invertierender Eingang mit den eingangsseitigen Einrichtungen (228) und der nicht-invertierende Eingang mit der Bezugspotentialquelle (230) gekoppelt ist,
daß der nicht-invertierende Eingang der ersten Differentialzelle (203) mit dem Ausgang des Operationsverstärkers sowie der invertierende Eingang der ersten Differentialzelle (203) mit der Bezugspotentialquelle (230) gekoppelt sind und ferner der Ausgang der ersten Differentialzelle (203) am invertierenden Eingang des Operationsverstärkers liegt, und daß ein Eingang der zweiten Differentialzelle (205) mit dem Ausgang des Operationsverstärkers und der andere Eingang der zweiten Differentialzelle (205) mit der Bezugspotentialquelle (230) gekoppelt ist.

10. Schaltung mit variabler Verstärkung nach einem der vorstehenden Ansprüche,
**dadurch gekennzeichnet,**
daß das Tonfrequenzausgangssignal (I_{OUT}) der variablen Verstärkerschaltung um 180° phasenverschoben gegenüber dem Tonfrequenzeingangssignal (I_{IN}) an den eingangsseitigen Einrichtungen (228) ist.

11. Schaltung mit variabler Verstärkung nach einem der Ansprüche 1 bis 9,
**dadurch gekennzeichnet,**
daß das Tonfrequenzausgangssignal (I_{OUT}) der variablen Verstärkerschaltung in Phase mit dem Tonfrequenzeingangssignal (I_{IN}) an den eingangsseitigen Einrichtungen (228) ist.

12. Schaltung mit variabler Verstärkung nach einem der vorstehenden Ansprüche,
**dadurch gekennzeichnet,**
daß die Verstärkerschaltung bis herunter 0,95 V betriebsfähig ist.

## Revendications

1. Circuit à gain variable comprenant ; des moyens d'entrée (228) pour entrer un signal d'entrée audio (I_{IN}) ; des moyens de sortie pour sortir un signal de sortie audio (I_{OUT}) ; des moyens amplificateurs (226/226A) ayant une entrée et une sortie ; une source (230) de potentiel de référence ; une première cellule différentielle (203) ayant des entrées inverseuse et non-inverseuse, une sortie et une première borne de courant de commande, dans laquelle une entrée de ladite première cellule différentielle (203) est couplée à ladite sortie desdits moyens amplificateurs (226/226A), et l'autre desdites entrées est couplée à ladite source (230) de potentiel de référence ; une seconde cellule différentielle (205) ayant des entrées inverseuse et non-inverseuse, une sortie et une seconde borne de courant de commande, dans laquelle une entrée de ladite seconde cellule différentielle est couplée à ladite sortie desdits moyens amplificateurs (226/226A) et l'autre desdites entrées est couplée à ladite source (230) du potentiel de référence, et caractérisé en ce que le circuit à gain variable comprend, en outre, une première et une seconde sources (232, 234, 236, 238) de courant de commande (Iₐ, I_{b}) ; ladite sortie de ladite première cellule différentielle (203) et les moyens d'entrée (228) sont couplés à ladite entrée desdits moyens amplificateurs (226/226A) selon une relation de rétroaction négative, et en ce que ladite première borne de courant de commande est couplée à ladite première source (232, 236, 238) de courant de commande (Iₐ) ; ladite sortie de ladite seconde cellule différentielle (206) est couplée auxdits moyens de sortie (I_{OUT}), et ladite seconde borne de courant de commande est couplée à ladite seconde source (234, 238) de courant de commande (I_{b}) ; et le rapport entre lesdits premier et second courants de commande (Iₐ, I_{b}) commande le gain dudit circuit à gain variable.

2. Circuit à gain variable selon la revendication 1, caractérisé, en outre, en ce que le gain dudit circuit est sensiblement égal au rapport (I_{b}/Iₐ) entre ledit second courant de commande (I_{b}) et ledit premier courant de commande (Iₐ).

3. Circuit à gain variable selon l'une quelconque des revendications précédentes, caractérisé, en outre, en ce que lesdits moyens amplificateurs (226) ont une seconde entrée, en ce que la première entrée desdits moyens amplificateurs (226) est couplée auxdits moyens d'entrée (228) et la seconde entrée desdits moyens amplificateurs (226) est couplée à ladite source (230) de potentiel de référence ; dans lequel l'entrée non-inverseuse de ladite première cellule différentielle (203) est couplée à la sortie desdits moyens -amplificateurs (226) et l'entrée inverseuse de ladite première cellule différentielle (203) est couplée à ladite source (230) de potentiel de référence, et dans lequel la sortie de ladite première cellule différentielle (203) est couplée à la première entrée desdits moyens amplificateurs (226).

4. Circuit à gain variable selon l'une quelconque des revendications précédentes, dans lequel lesdits moyens amplificateurs (226/226A) comprennent un transistor.

5. Circuit à gain variable selon l'une quelconque des revendications précédentes, dans lequel lesdits moyens amplificateurs (226) comprennent un amplificateur opérationnel.

6. Circuit à gain variable selon l'une quelconque des revendications précédentes, apte à être réalisé sous la forme d'un circuit intégré.

7. Circuit à gain variable selon l'une quelconque des revendications précédentes, dans lequel ladite première cellule différentielle (203) comprend un premier et un second transistors à couplage d'émetteurs NPN (206, 208) couplés à un miroir de courant (214) comprenant un premier et un second transistors PNP (218, 220), chacun desdits transistors ayant une base, un émetteur et un collecteur, dans lequel les collecteurs desdits premiers transistors NPN et PNP (206, 218) sont couplés entre eux et les collecteurs desdits seconds transistors NPN et PNP (208, 220) sont couplés entre eux, et dans lequel, en outre, la base et le collecteur dudit second transistor PNP (220) sont couplés ensemble et les bases desdits premier et second transistors PNP (218, 220) sont couplées entre elles, dans lequel la base dudit premier transistor NPN (206) comprend l'entrée inverseuse de ladite première cellule différentielle (203) et la base dudit second transistor NPN (208) constitue l'entrée non-inverseuse de ladite cellule différentielle (203) et la connexion des collecteurs desdits premiers transistors PNP et NPN (206, 218) comprend la sortie de ladite première cellule différentielle (203), et dans lequel la connexion des émetteurs desdits premier et second transistors NPN (206, 208) est couplée à ladite première borne de courant de commande.

8. Circuit à gain variable selon l'une quelconque des revendications précédentes, dans lequel chacune desdites cellules différentielles (203/205) comprend un premier et un second transistors à couplage d'émetteurs (206, 208/210, 212) couplés à un miroir de courant (214/216) comprenant un premier et un second transistors miroirs de courant (218, 220/222, 224) de polarité opposée à la polarité desdits premier et second transistors à couplage d'émetteurs (206, 208/210, 212), chacun desdits transistors ayant une base, un émetteur et un collecteur, dans lequel les émetteurs desdits premier et second transistors miroirs de courant (218, 220, 222, 224) sont couplés à une source de tension (225), dans lequel les collecteurs desdits premiers transistors (206, 218/210, 222) sont couplés entre eux et les collecteurs desdits seconds transistors (208, 220/212, 224) sont couplés entre eux, et dans lequel, de plus, la base et le collecteur dudit second transistor miroir de courant (220/224) sont couplés ensemble et les bases desdits premier et second transistors miroirs de courant (218, 220/222, 224) sont couplées ensemble, dans lequel la base dudit premier transistor à couplage d'émetteurs (206/210) comprend l'entrée inverseuse de ladite cellule différentielle (203/205) et la base dudit second transistor à couplage d'émetteurs (208, 212) comprend l'entrée non-inverseuse de ladite cellule différentielle (203/205) et la connexion des collecteurs desdits premiers transistors (206, 218/210, 222) comprend la sortie de ladite cellule différentielle (203/205), et dans lequel la connexion des émetteurs desdits premier et second transistors à couplage d'émetteurs (206, 208/210, 212) est couplée à la borne de courant de commande de ladite cellule différentielle (203/205).

9. Circuit à gain variable selon la revendication 1, caractérisé, en outre, en ce que lesdits moyens amplificateurs (226) comprennent un amplificateur opérationnel ayant des entrées inverseuse et non-inverseuse et une sortie, en ce que l'entrée inverseuse dudit amplificateur opérationnel est couplée auxdits moyens d'entrée (228) et ladite entrée non-inverseuse est couplée à ladite source (230) de potentiel de référence ; en ce que l'entrée non-inverseuse de ladite première çellule différentielle (203) est couplée à la sortie dudit amplificateur opérationnel, l'entrée inverseuse de ladite première cellule différentielle (203) est couplée à ladite source (230) de potentiel de référence, et la sortie de ladite première cellule différentielle (203) est couplée à l'entrée inverseuse dudit amplificateur opérationnel ; et en ce qu'une entrée de ladite seconde cellule différentielle (205) est couplée à la sortie dudit amplificateur opérationnel et l'autre desdites entrées de ladite seconde cellule différentielle (205) est couplée à ladite source (230) de potentiel de référence.

10. Circuit à gain variable selon l'une quelconque des revendications précédentes, dans lequel le signal de sortie audio (I_{OUT}) dudit circuit à gain variable est déphasé de 180° par rapport au signal d'entrée audio (I_{IN}) sur lesdits moyens d'entrée (228).

11. Circuit à gain variable selon l'une quelconque des revendications 1 à 9, dans lequel le signal de sortie audio (I_{OUT}) dudit circuit à gain variable est en phase avec le signal d'entrée audio (I_{IN}) sur lesdits moyens d'entrée (228).

12. Circuit à gain variable selon l'une quelconque des revendications précédentes, dans lequel ledit circuit variable perfectionné est capable de fonctionner à des tensions aussi faibles que 0,95 volt.
